# EUROPEAN PATENT APPLICATION

(11) **EP 2 680 325 A2**
(43) Date of publication of application: **01.01.2014**
(21) Application number: 13171551.8
(22) Date of filing: 11.06.2013
(51) Int. Cl.: H01L 33/00, H01L 33/46

(54) **Method of manufacturing a light emitting diode**

(30) Priority: 28.06.2012 JP 2012145451
(71) Applicant: NITTO DENKO CORPORATION, Ibaraki-shi, Osaka 567-8680 (JP)
(72) Inventor: Takahashi, Tomokazu, Ibaraki-shi, Osaka 567-8680 (JP); Akizuki, Shinya, Ibaraki-shi, Osaka 567-8680 (JP); Sugimura, Toshimasa, Ibaraki-shi, Osaka 567-8680 (JP); Matsumura, Takeshi, Ibaraki-shi, Osaka 567-8680 (JP); Uenda, Daisuke, Ibaraki-shi, Osaka 567-8680 (JP)
(74) Representative: Gill, Stephen Charles

(57) **Abstract**

A method of manufacturing an LED according to an embodiment of the present invention includes:
back-grinding a substrate (12) of an LED wafer including the substrate (12) and a light emitting element (11) formed on one surface of the substrate;
forming, after the back-grinding, a reflective layer on an outer side of the substrate; and
attaching, on an outer side of the light emitting element of the LED wafer, a heat-resistant pressure-sensitive adhesive sheet (20).

## Description

### BACKGROUND OF THE INVENTION

### 1. Field of the Invention

The present invention relates to a method of manufacturing an LED.

### 2. Description of the Related Art

Hitherto, in manufacture of an LED, a light emitting element is laminated on a substrate to form an LED wafer, and then a surface of the substrate on a side opposite to the light emitting element is ground (back-ground) to thin the substrate (for example, Japanese Patent Application Laid-open Nos. 2005-150675 and 2002-319708). Generally, this grinding is carried out while fixing a surface of the substrate on the light emitting element side to a table via a pressure-sensitive adhesive wax. The LED wafer that has undergone grinding is subjected to, for example, steps of heating the wax to release the LED wafer, cleaning the wax adhering on the LED wafer, cutting (dicing) the LED wafer to singulate small element pieces, and forming a reflective layer on the surface of the substrate on the side opposite to the light emitting element. The LED wafer that has undergone the back-grinding step is very thin, and hence there is a problem in that, in grinding the substrate and in the steps of the post-process, damage such as cracking easily occurs.

Generally, the reflective layer is formed by, for example, a vapor deposition method such as a MOCVD method and an ion assisted electron beam deposition method. In the case of the MOCVD method, after an LED wafer is placed on a table with the reflective layer forming side up (that is, with the outer side of the substrate up), an outer surface of the substrate is subjected to vapor deposition processing. Further, in the case of the ion assisted electron beam deposition method, the LED wafer is covered with a lid from a side opposite to the reflective layer forming side (that is, the light emitting element side), and a reflective layer forming surface (that is, the outer surface of the substrate) is exposed. The exposed surface is subjected to vapor deposition processing. However, in such conventional manufacturing methods, the following problem may arise. A metal enters a space between the surface of the LED wafer on the side opposite to the reflective layer forming surface (that is, the surface on the light emitting element side) and the table or the lid, and thus a metal layer is also formed on the outer side of the light emitting element. Thus, the brightness of the LED is negatively affected. Such a problem becomes more conspicuous when the LED wafer to be subjected to the forming of the reflective layer is warped, and when the LED wafer is warped during the reflective layer formation.

### SUMMARY OF THE INVENTION

The present invention has been made to address the above-mentioned conventional problem, and has an object to provide a method of manufacturing an LED, which is capable of manufacturing an LED with high yields by preventing damage to an LED wafer, and further, capable of preventing a metal layer from being formed on an outer side of a light emitting element in a reflective layer forming step.

A method of manufacturing an LED according to an embodiment of the present invention includes:
back-grinding a substrate of an LED wafer including the substrate and a light emitting element formed on one surface of the substrate;
forming, after the back-grinding, a reflective layer on an outer side of the substrate; and
attaching, on an outer side of the light emitting element of the LED wafer, a heat-resistant pressure-sensitive adhesive sheet.

In an embodiment of the present invention, the heat-resistant pressure-sensitive adhesive sheet includes a hard base member and a pressure-sensitive adhesive layer.

In an embodiment of the present invention, the back-grinding includes the attaching of the heat-resistant pressure-sensitive adhesive sheet, and the LED wafer is subjected to the forming of the reflective layer under a state in which the heat-resistant pressure-sensitive adhesive sheet is still attached to the LED wafer.

According to the present invention, the heat-resistant pressure-sensitive adhesive sheet is attached to the outer side of the light emitting element of the LED wafer, and hence in the steps of manufacturing an LED, the LED wafer is prevented from being damaged to manufacture the LED with high yields. Further, the LED wafer is subjected to the reflective layer forming step under a state in which the heat-resistant pressure-sensitive adhesive sheet is still attached to the LED wafer, and hence the metal layer may be prevented from being formed on the outer side of the light emitting element. Further, the above-mentioned effects may be obtained without re-attaching a single heat-resistant pressure-sensitive adhesive sheet, and hence the LED may be efficiently manufactured.

### BRIEF DESCRIPTION OF THE DRAWINGS

In the accompanying drawings:
FIGS. **1A** to **1D** are schematic views illustrating a back-grinding step in a method of manufacturing an LED according to an embodiment of the present invention;
FIG. **2** is a schematic sectional view of an LED wafer used in the method of manufacturing an LED according to the embodiment of the present invention;
FIGS. **3A** to **3C** are schematic views illustrating a reflective layer forming step in the method of manufacturing an LED according to the embodiment of the present invention;
FIGS. **4A** to **4D** are schematic views illustrating a dicing step in the method of manufacturing an LED according to the embodiment of the present invention; and
FIGS. **5A** to **5F** are schematic views illustrating respective steps of a method of manufacturing an LED according to another embodiment of the present invention.

### DETAILED DESCRIPTION OF THE PREFERRED EMBODIMENTS

A method of manufacturing an LED according to an embodiment of the present invention includes a back-grinding step of grinding a substrate of an LED wafer including the substrate and a light emitting element formed on one surface of the substrate, and a reflective layer forming step of forming a reflective layer on an outer side of the substrate. The reflective layer is preferred to be formed by a vapor deposition method. In the present invention, the LED wafer is protected by the heat-resistant pressure-sensitive adhesive sheet, and hence the damage (for example, cracking) to the LED wafer can be prevented during the manufacturing steps such as the back-grinding step and the reflective layer forming step and during handling between the steps. Further, in the reflective layer forming step, a metal layer can be prevented from being formed on the outer side of the light emitting element (details are described later). It is preferred that the LED wafer be subjected to the reflective layer forming step under a state in which the heat-resistant pressure-sensitive adhesive sheet which has been attached to the LED wafer in the back-grinding step is still attached thereto (that is, without re-attachment).

### A. Back-grinding Step

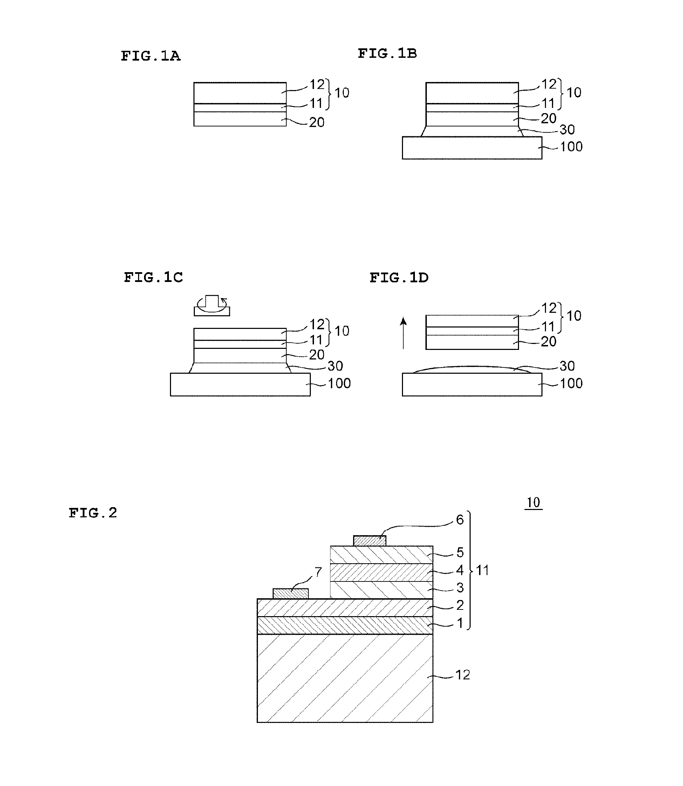

FIGS. **1A** to **1D** are schematic views illustrating a back-grinding step in a method of manufacturing an LED according to an embodiment of the present invention. Further, FIG. **2** is a schematic sectional view of an LED wafer **10.** The LED wafer **10** includes a light emitting element **11** and a substrate **12.** The light emitting element **11** includes a buffer layer **1,** an n-type semiconductor layer **2,** a light emitting layer **3,** a p-type semiconductor layer **4,** a transparent electrode **5,** and electrodes **6** and **7.** The light emitting layer **3** includes, for example, gallium nitride-based compounds (e.g., GaN, AlGaN, and InGaN), gallium phosphide-based compounds (e.g., GaP and GaAsP), gallium arsenide-based compounds (e.g., GaAs, AlGaAs, and AlGaInP), and zinc oxide (ZnO)-based compounds. Note that, although not illustrated, the light emitting element **11** may include any other appropriate members. The substrate **12** is made of any appropriate material. Examples of the material for constituting the substrate **12** include sapphire, SiC, GaAs, GaN, and GaP. The effect of the present invention, that is, preventing damage to the LED wafer **10,** is markedly obtained when the employed LED wafer **10** is made of such a hard and brittle material as those materials.

In the back-grinding step, first, as illustrated in FIG. **1A****,** a heat-resistant pressure-sensitive adhesive sheet **20** is attached onto an outer side of the light emitting element **11** of the LED wafer **10.**

As the heat-resistant pressure-sensitive adhesive sheet **20,** any appropriate pressure-sensitive adhesive sheet may be used as long as the effect of the present invention may be obtained. It is preferred to use a heat-resistant pressure-sensitive adhesive sheet which does not melt and generate a gas and can maintain its adhesion even when the heat-resistant pressure-sensitive adhesive sheet is exposed under high temperature (for example, 135°C to 200°C) at the time of vapor deposition processing in the reflective layer forming step of the post-process.

The heat-resistant pressure-sensitive adhesive sheet **20** includes, for example, a base member and a pressure-sensitive adhesive layer. The pressure-sensitive adhesive layer may be provided on one surface of the base member, or may be provided on each of both surfaces thereof.

As a material for constituting the base member, any appropriate material may be used as long as the effect of the present invention may be obtained. Examples of the material for constituting the base member include resins such as polyimide and polyethylene naphthalate. With use of such resins, a heat-resistant pressure-sensitive adhesive sheet excellent in heat-resisting performance can be obtained.

When the base member is made of a resin, the thickness of the base member is preferably 10 µm to 1,000 µm, more preferably 25 µm to 700 µm.

According to the embodiment, the base member is a hard base member. In this specification, the hard base member refers to a base member made of an inorganic material having a Young's modulus of 70 GPa or more at 25°C. With use of the heat-resistant pressure-sensitive adhesive sheet including the hard base member, the reflective layer forming step can be performed after the warpage of the LED wafer is corrected, and further, the warpage can be prevented from occurring during the reflective layer forming step. As a result, the effect of the present invention that the metal layer is prevented from being formed on the outer side of the light emitting element **11** becomes more conspicuous.

As a material for constituting the hard base member, there may be given, for example: silicon; glass; metal such as stainless steel; and a ceramic.

When the base member is the hard base member, the thickness of the hard base member is preferably 0.2 mm to 50 mm, more preferably 0.3 mm to 10 mm.

As a pressure-sensitive adhesive constituting the pressure-sensitive adhesive layer, any appropriate pressure-sensitive adhesive may be used. It is preferred to use a pressure-sensitive adhesive which does not melt and generate a gas and can maintain its adhesion even under high temperature (for example, 135°C to 200°C) at the time of vapor deposition in the reflective layer forming step. Further, the pressure-sensitive adhesive is preferred to be peeled off without adhesive residue even after heating. Examples of the pressure-sensitive adhesive include an acrylic pressure-sensitive adhesive, a silicone-based pressure-sensitive adhesive, and a polyimide-based pressure-sensitive adhesive. Examples of the polyimide-based pressure-sensitive adhesives include a polyimide-based resin obtained by imidizing a polyamic acid obtained by a reaction of an acid anhydride and a diamine having an ester structure. It is preferred that the mixing ratio of the diamine having the ether structure when the acid anhydride is reacted with the diamine having the ether structure be 5 parts by weight to 90 parts by weight with respect to 100 parts by weight of the acid anhydride.

Further, a foaming agent may be added to the pressure-sensitive adhesive layer. The pressure-sensitive adhesive layer having the foaming agent added thereto exhibits a peel property by heating. Specifically, in the pressure-sensitive adhesive layer having the foaming agent added thereto, the foaming agent is foamed or expanded by heating, and thus the adhesion is reduced or lost. With use of a heat-resistant pressure-sensitive adhesive sheet including such a pressure-sensitive adhesive layer, the LED wafer is sufficiently fixed during grinding, and the LED wafer can be easily released after grinding. As a result, the damage to the LED wafer can be markedly prevented. Further, automated steps can be easily designed. Any appropriate foaming agent may be used as the foaming agent. Examples of the foaming agent include: inorganic foaming agents such as ammonium carbonate, ammonium hydrogen carbonate, sodium hydrogen carbonate, ammonium nitrite, sodium boron hydride, and an azide; and organic foaming agents such as an alkane chloride fluoride, an azo-based compound, a hydrazine-based compound, a semicarbazide-based compound, a triazole-based compound, and an N-nitroso-based compound. Details of the pressure-sensitive adhesive layer containing the foaming agent as described above are described in Japanese Patent Application Laid-open Nos. Hei 5-043851, Hei 2-305878, and Sho 63-33487, the contents of which are hereby incorporated by reference into this specification.

The thickness of the pressure-sensitive adhesive layer is preferably 1 µm to 100 µm, more preferably 3 µm to 60 µm.

After the heat-resistant pressure-sensitive adhesive sheet **20** is attached, the LED wafer with the heat-resistant pressure-sensitive adhesive sheet is fixed on a table **100** (FIG. **1B****).** The LED wafer with the heat-resistant pressure-sensitive adhesive sheet is fixed, for example, as illustrated in FIG. **1B****,** by attaching the heat-resistant pressure-sensitive adhesive sheet **20** to the table **100** via a pressure-sensitive adhesive wax **30.** As the pressure-sensitive adhesive wax **30,** any appropriate wax may be used as long as the LED wafer **10** may be satisfactorily fixed. Examples of the pressure-sensitive adhesive wax **30** include paraffin-based wax. In the present invention, the LED wafer **10** and the pressure-sensitive adhesive wax **30** are not brought into contact with each other, and hence the LED wafer **10** can be prevented from being stained.

After the LED wafer **10** is fixed as described above, as illustrated in FIG. **1C****,** a surface of the LED wafer **10** on a side opposite to the light emitting element **11** (that is, the substrate **12)** is ground. With this grinding, the substrate **12** can be thinned to a desired thickness. The thickness of the substrate **12** that has undergone grinding is preferably 10 µm to 500 µm, more preferably 50 µm to 300 µm, most preferably 80 µm to 150 µm. Further, the diameter of the employed LED wafer **10** is preferably 2 inches or more, more preferably 3 inches or more, most preferably 4 inches or more. The upper limit of the diameter of the LED wafer **10** is not particularly limited, but in practical use, the diameter is about 12 inches, for example. In the present invention, the LED wafer **10** is protected by the heat-resistant pressure-sensitive adhesive sheet **20,** and hence the LED wafer **10** may be prevented from being damaged during grinding. Further, the LED wafer **10** can be prevented from being damaged as described above, and hence a large-size (for example, 4 inches or more) LED wafer larger than the conventional one can be handled, and hence the LED can be manufactured with high yields.

After the substrate **12** is ground as described above, as illustrated in FIG. **1D****,** the LED wafer with the heat-resistant pressure-sensitive adhesive sheet is released from the table **100.** For example, heating is performed until the pressure-sensitive adhesive wax **30** exhibits flowability, and thus the LED wafer with the heat-resistant pressure-sensitive adhesive sheet is released from the table **100.** In the present invention, the LED wafer **10** is protected by the heat-resistant pressure-sensitive adhesive sheet **20,** and hence the LED wafer **10** may be prevented from being damaged when the LED wafer **10** is released from the table **100.**

After the LED wafer with the heat-resistant pressure-sensitive adhesive sheet is released from the table **100,** the pressure-sensitive adhesive wax **30** is cleaned as necessary. The pressure-sensitive adhesive wax **30** can be cleaned by immersing the LED wafer with the heat-resistant pressure-sensitive adhesive sheet into an organic solvent which can dissolve the pressure-sensitive adhesive wax.

### B. Reflective Layer Forming Step

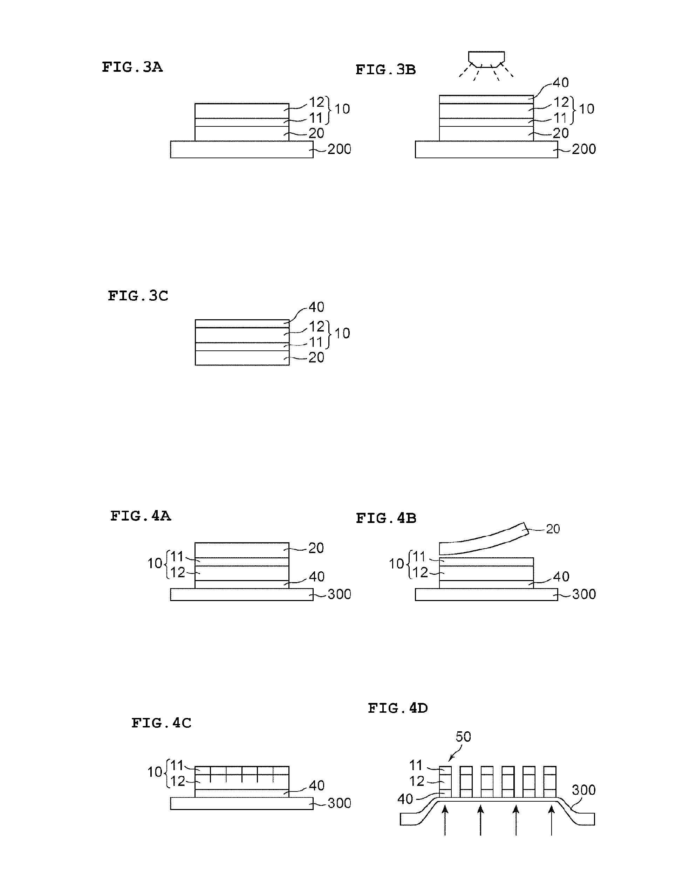

The LED wafer is subjected to the reflective layer forming step after the back-grinding step. FIGS. **3A** to **3C** are schematic views illustrating the reflective layer forming step in the method of manufacturing an LED according to the embodiment of the present invention. FIGS. **3A** to **3C** illustrate, as a representative example, an embodiment in which a reflective layer **40** is formed on an outer side of the substrate **12** of the LED wafer **10** by a metal organic chemical vapor deposition method (MOCVD method).

In the present invention, the LED wafer **10** having the heat-resistant pressure-sensitive adhesive sheet **20** attached thereto is subjected to the reflective layer forming step. At this time, the heat-resistant pressure-sensitive adhesive sheet **20** is attached to the light emitting element **11** side of the LED wafer **10.** The heat-resistant pressure-sensitive adhesive sheet **20** may not be re-attached between steps and the heat-resistant pressure-sensitive adhesive sheet **20** attached in the back-grinding step may be used as it is, or a new heat-resistant pressure-sensitive adhesive sheet **20** re-attached between steps may be used. When the heat-resistant pressure-sensitive adhesive sheet **20** is used without re-attachment between steps, the LED can be efficiently manufactured. When the heat-resistant pressure-sensitive adhesive sheet **20** is re-attached between steps, the heat-resistant pressure-sensitive adhesive sheet **20** is peeled off after the back-grinding step, and thus the pressure-sensitive adhesive wax **30** can be removed together with the heat-resistant pressure-sensitive adhesive sheet **20.** In this manner, cleaning of the wax can be omitted. In the reflective layer forming step, the LED wafer with the heat-resistant pressure-sensitive adhesive sheet is placed on a table **200** with the heat-resistant pressure-sensitive adhesive sheet **20** side down (FIG. **3A****),** and after that, the reflective layer **40** is formed on the side of the LED wafer **10** opposite to the heat-resistant pressure-sensitive adhesive sheet **20** (that is, the substrate **12** side) (FIG. **3B****).** By forming the reflective layer **40,** the amount of light to be extracted from the light emitting element **11** can be increased.

As a material for constituting the reflective layer **40,** any appropriate material may be used as long as the light from the light emitting element **11** may be satisfactorily reflected. Examples of the material for constituting the reflective layer **40** include metals such as aluminum, silver, gold, palladium, platinum, rhodium, and ruthenium. The reflective layer **40** made of a metal may be formed by, for example, a vapor deposition method (for example, as in the illustrated example, a MOCVD method). It is preferred that an underlayer made of, for example, SiO₂, TiO₂, ZrO₂, and/or MgF₂ be formed on the outer side of the substrate **12** of the LED wafer **10,** and then the reflective layer **40** made of a metal be formed by a vapor deposition method. According to the present invention, the LED wafer **10** having the heat-resistant pressure-sensitive adhesive sheet **20** attached to the outer side of the light emitting element **11** is subjected to the reflective layer forming step. Therefore, the heat-resistant pressure-sensitive adhesive sheet **20** plays a role as a so-called masking sheet, and hence the metal may be prevented from entering behind the LED wafer **10** and depositing on the light emitting element **11.** Further, as described above, when the hard base member is used as the base member of the heat-resistant pressure-sensitive adhesive sheet, the warpage of the LED wafer can be corrected, and hence it is possible to provide a manufacturing method having high reliability in terms of preventing the metal from depositing on the light emitting element **11.** According to the manufacturing method of the present invention, a metal layer is hardly formed on the light emitting element **11,** and hence an LED having high brightness can be obtained.

In the present invention, the method of forming the reflective layer **40** is not limited to the MOCVD method, and any other appropriate methods may be employed. Examples of the other appropriate methods include an ion assisted electron beam deposition method. In the ion assisted electron beam deposition method, generally, the LED wafer is covered with a lid from a side opposite to the reflective layer forming side (that is, from the light emitting element side), and a reflective layer forming surface (that is, the outer surface of the substrate) is exposed. The exposed surface is subjected to vapor deposition processing. According to the present invention, by attaching the heat-resistant pressure-sensitive adhesive sheet on the outer side of the light emitting element, also in the case of employing the ion assisted electron beam deposition method, the metal may be prevented from entering behind the LED wafer and depositing on the light emitting element.

As described above, the LED wafer **10** having the reflective layer **40** formed thereon can be obtained (FIG. **3C**). The heat-resistant pressure-sensitive adhesive sheet **20** may be peeled off immediately after the reflective layer forming step, or the LED wafer **10** may be subjected to the post-process under a state in which the heat-resistant pressure-sensitive adhesive sheet **20** is still attached thereto. When the LED wafer **10** is subjected to the post-process under a state in which the heat-resistant pressure-sensitive adhesive sheet **20** is still attached thereto, the LED wafer **10** can be prevented from being damaged during the post-process and during handling between steps.

### C. Other Steps

The method of manufacturing an LED of the present invention may further include any other appropriate steps. Examples of the other appropriate steps include a step of cutting the LED wafer **10** to singulate small element pieces (dicing step).

FIGS. **4A** to **4D** are schematic views illustrating a dicing step in the method of manufacturing an LED according to the embodiment of the present invention. In this embodiment, the LED wafer **10** that has undergone the reflective layer forming step is subjected to the dicing step. Specifically, the LED wafer **10** is retained on dicing tape **300** with the reflective layer **40** side of the LED wafer **10** having the reflective layer **40** formed thereon down (FIG. **4A****).** When the LED wafer **10** is subjected to the dicing step under a state in which the heat-resistant pressure-sensitive adhesive sheet **20** is still attached thereto as in the illustrated example, it is preferred that the heat-resistant pressure-sensitive adhesive sheet **20** be peeled off after the LED wafer **10** is retained on the dicing tape **300** (FIG. **4B****).** After that, the LED wafer **10** (substantially, the substrate **12)** is half-cut in the thickness direction (FIG. **4C****).** After that, the dicing tape **300** is expanded so that the LED wafer **10** having the reflective layer **40** formed thereon is split from the cut portion as an origin to obtain LEDs **50** singulated into small element pieces (FIG. **4D**).

Referring to FIGS. **4C** and **4D****,** description has been made of the embodiment in which the LED wafer **10** is half-cut so as to split the LED wafer **10** from the cut portion as the origin (scribe dicing). In FIG. **4C****,** the LED wafer **10** is half-cut from the light emitting element **11** side. However, the dicing tape **300** may be alternatively attached with the substrate **12** (reflective layer **40)** side up, and the LED wafer **10** may be half-cut from the substrate **12** side (reflective layer **40** side). Further, as a method of cutting the LED wafer, in addition to the above-mentioned scribe dicing, any appropriate method may be adopted. Examples of other methods include a method of cutting the LED wafer in the entire thickness direction to singulate the small element pieces through expanding, and a method of laser cutting only the center portion of the LED wafer **10** in the thickness direction to split the LED wafer from the cut portion as an origin (stealth dicing).

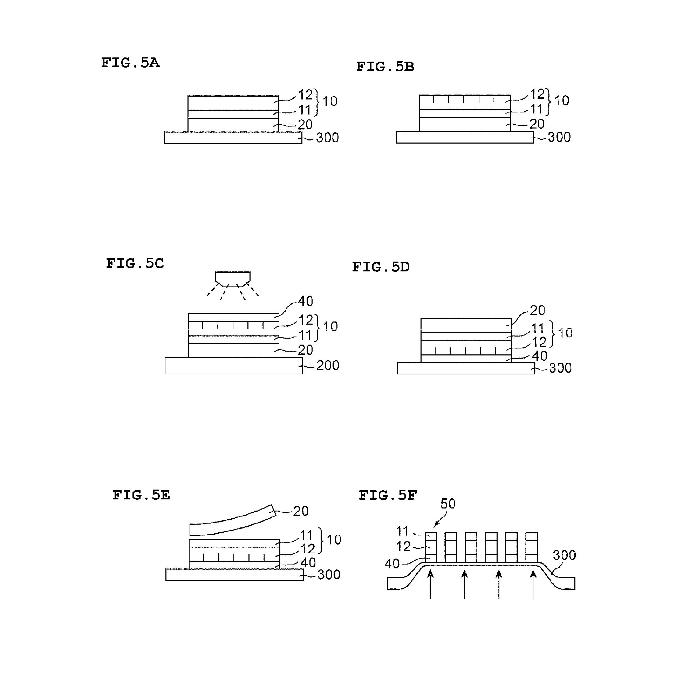

Referring to FIGS. **4A** to **4D****,** description has been made of the embodiment in which, prior to the formation of the cut portion for splitting, the reflective layer forming step is performed. The reflective layer forming step may be performed prior to the formation of the cut portion as described above, or may be performed after the cut portion is formed as illustrated in FIGS. **5A** to **5F****.** In an embodiment of the present invention illustrated in FIGS. **5A** to **5F****,** the LED wafer with the heat-resistant pressure-sensitive adhesive sheet, which has undergone the back-grinding step, is retained on the dicing tape **300** with the heat-resistant pressure-sensitive adhesive sheet **20** side down (FIG. **5A****),** and after that, the LED wafer **10** is half-cut from the substrate **12** side (FIG. **5B****).** Subsequently, the LED wafer **10** having the cut portion formed therein as described above is subjected to the reflective layer forming step. That is, the LED wafer **10** is placed on the table **200** with the light emitting element **11** side (heat-resistant pressure-sensitive adhesive sheet **20** side) down, and the reflective layer **40** is formed on the substrate **12** side of the LED wafer **10** (FIG. **5C****).** The LED wafer **10** may be placed on the table **200** under a state in which the dicing tape **300** is still adhering on the outer side of the heat-resistant pressure-sensitive adhesive sheet **20,** or may be placed on the table **200** after the dicing tape **300** is peeled off (in the illustrated example, the LED wafer **10** is placed after the dicing tape **300** is peeled off). Subsequently, the LED wafer **10** having the reflective layer **40** formed thereon is retained on the dicing tape **300** again with the heat-resistant pressure-sensitive adhesive sheet **20** side up (FIG. **5D****).** Then, the heat-resistant pressure-sensitive adhesive sheet **20** is peeled off (FIG. **5E****).** After that, the dicing tape **300** is expanded and the LED wafer **10** is split from the cut portion as an origin, to thereby obtain the LEDs **50** singulated into small element pieces (FIG. **5F****).**

It is preferred that, as illustrated in FIGS. **4A** to **4D** and **5A** to **5F**, after the reflective layer **40** is formed on the LED wafer with the heat-resistant pressure-sensitive adhesive sheet, the LED wafer be subjected to the post-process under a state in which the heat-resistant pressure-sensitive adhesive sheet is still attached thereto (FIGS. **4A** and **5D**). According to those embodiments, the heat-resistant pressure-sensitive adhesive sheet **20** protects the LED wafer **10,** and thus the LED wafer **10** can be prevented from being damaged during handling.

## Claims

1. A method of manufacturing an LED, the method comprising:
back-grinding a substrate of an LED wafer including the substrate and a light emitting element formed on one surface of the substrate;
forming, after the back-grinding, a reflective layer on an outer side of the substrate; and
attaching, on an outer side of the light emitting element of the LED wafer, a heat-resistant pressure-sensitive adhesive sheet.

2. A method of manufacturing an LED according to claim 1, wherein the heat-resistant pressure-sensitive adhesive sheet comprises a hard base member and a pressure-sensitive adhesive layer.

3. A method of manufacturing an LED according to claim 1 or 2,
wherein the back-grinding comprises the attaching of the heat-resistant pressure-sensitive adhesive sheet, and
wherein the LED wafer is subjected to the forming of the reflective layer under a state in which the heat-resistant pressure-sensitive adhesive sheet is still attached to the LED wafer.
